# EUROPEAN PATENT SPECIFICATION

(11) **EP 0 822 642 B1**
(45) Date of publication and mention of the grant of the patent: **27.03.2002**
(21) Application number: 97112999.4
(22) Date of filing: 29.07.1997
(51) Int. Cl.: H02K 11/04, H01L 25/11

(54) **A rectifier for an alternator, particularly for motor vehicles**
Gleichrichter für einen Wechselstromgenerator, insbesondere für Kraftfahrzeuge
Redresseur pour alternateur, notamment de véhicule automobile

(30) Priority: 02.08.1996 IT TO960674
(43) Date of publication of application: 04.02.1998
(73) Proprietor: Denso Manufacturing Italia S.p.A., 20121 Milano (IT)
(72) Inventor: Fagnano, Nicola, 55129 Pescara (IT); Prosperi, Mario, 66054 Vasto (Chieti) (IT); Di Pardo, Angelo, 66020 Palmoli (Chieti) (IT); Miccoli, Rocco, 66027 Ortona (Chieti) (IT)
(74) Representative: Quinterno, Giuseppe

(56) References cited:
- US-A- 4 419 597
- PATENT ABSTRACTS OF JAPAN vol. 017, no. 593 (E-1454), 28 October 1993 & JP 05 176505 A (NIPPONDENSO CO LTD), 13 July 1993
- PATENT ABSTRACTS OF JAPAN vol. 004, no. 040 (E-004), 28 March 1980 & JP 55 010871 A (NIPPON DENSO CO LTD), 25 January 1980

## Description

The present invention relates to a rectifier for an alternator for an internal combustion engine, particularly for motor vehicles.

More specifically, the subject of the invention is a rectifier comprising:
a pair of facing, cooling conductor plates, that is, a positive plate and a negative plate which are insulated from one another and to which are connected respective sets of positive or negative diodes having respective wire rheophores extending in the same direction substantially perpendicular to the plates, for connection to the phases of the alternator, and
an interconnection structure, also of generally arcuate shape, arranged facing and substantially parallel to one of the conductor plates on the opposite side to the other conductor plate and comprising a body of electrically-insulating material incorporating connecting conductor elements each having a first terminal and a second terminal for connection to the wire rheophores of a positive diode and of a negative diode, respectively, and a third terminal for connection to a phase of the armature winding of the alternator, the terminals projecting peripherally from the body of insulating material.

Such a rectifier is known for instance from prior art document US-A-4 419 597.

The rectifier according to the invention is characterized in that the outer sides of the positive and negative plates have respective pluralities of peripheral notches in corresponding relative positions and facing the third terminals of the interconnection structure, the peripheral notches of the conductor plate which are disposed between the interconnection structure and the other conductor plate being of a size such that the wire rheophores of the diodes carried by the other plate extend through them.

The characteristics and advantages of the invention will become clear from the following detailed description, given purely by way of non-limiting example, with reference to the appended drawings, in which:
Figure 1 is a sectioned view of a motor-vehicle alternator comprising a rectifier according to the invention,
Figure 2 is a front view of the alternator, taken on the arrow II of Figure 1,
Figure 3 is an exploded perspective view of a rectifier according to the invention, and
Figures 3a and 3b are respective side views of a portion of an interconnection structure of the rectifier of Figure 3, and of an insulating spacer element included in the rectifier according to the invention.

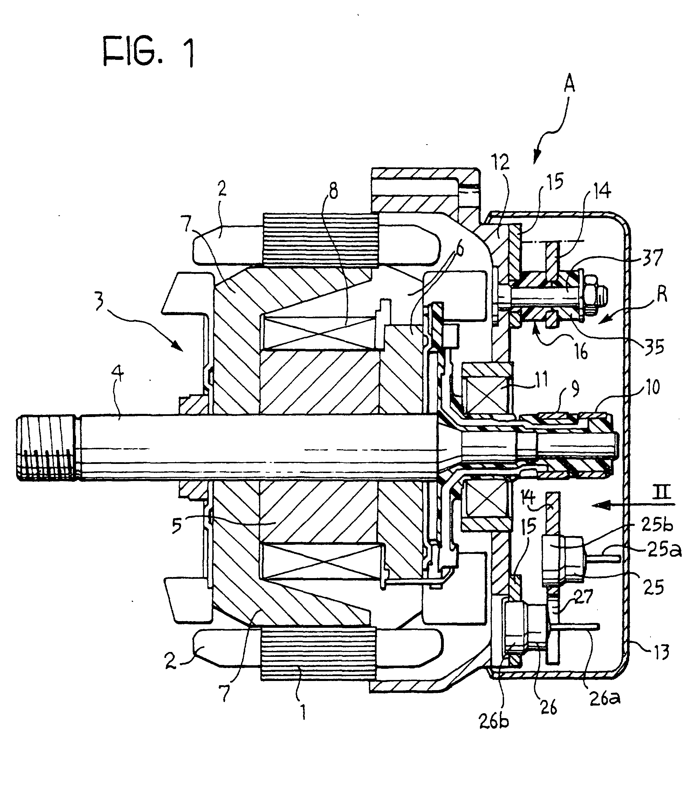

In Figure 1, an alternator of the general type usually used as a generator in a motor vehicle is generally indicated A.

The alternator comprises a stator 1 with a three-phase winding 2 and a rotor 3 carried by a shaft 4 coaxial with the stator. The rotor 3 comprises, in known manner, a core 5 mounted on the shaft 4 between two pole plates 6 and 7 which have respective interpenetrating appendages or poles (a "claw-pole" structure). The rotor 3 comprises a field winding, indicated 8, disposed around the core 5, between the pole plates 6 and 7. This winding is connected, in known manner, to a commutator comprising two conductor rings 9 and 10 on one end of the shaft 4. The shaft is supported for rotation by means of a pair of ball bearings, of which only one is shown in Figure 1, in which it is indicated 11. This bearing is shown in a cap 12 forming part of the alternator casing or shell. A bridge rectifier, generally indicated R, is mounted on the outer face of the cap 12. The rectifier is covered by an outer protective cap 13 fixed to the alternator casing.

The rectifier R shown by way of example in the drawings is of the three-phase type with eight diodes. Four of the diodes, known as "positive" diodes, have their cathodes connected to the positive terminal of a voltage supply (the battery of the vehicle). The other four diodes, known as "negative" diodes have their anodes connected to the negative terminal of the voltage supply, which is generally connected to earth. Three pairs of diodes are connected so as to form a three-phase bridge; these diodes are connected to the three phases of the stator winding 2 of the alternator A. The fourth pair of diodes is connected to the star point of the stator winding.

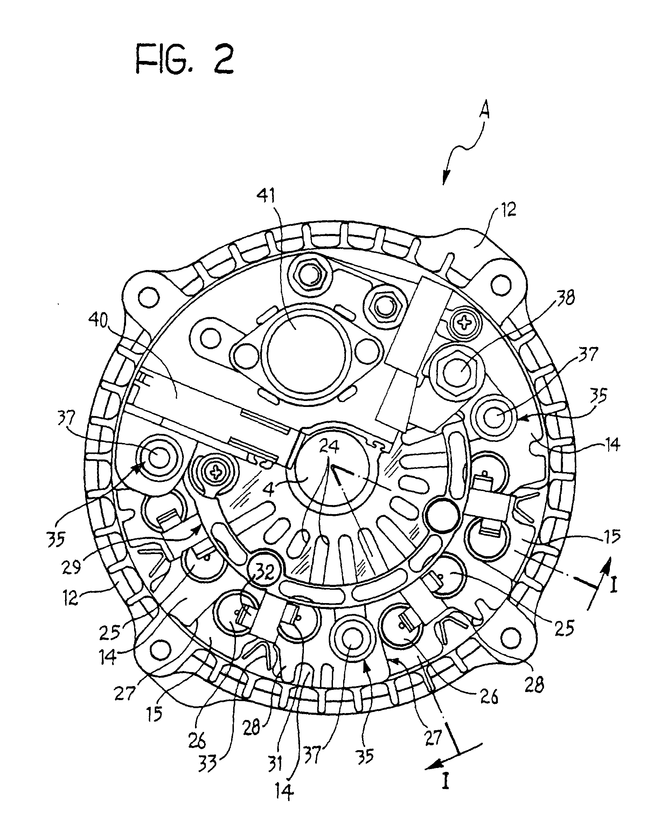

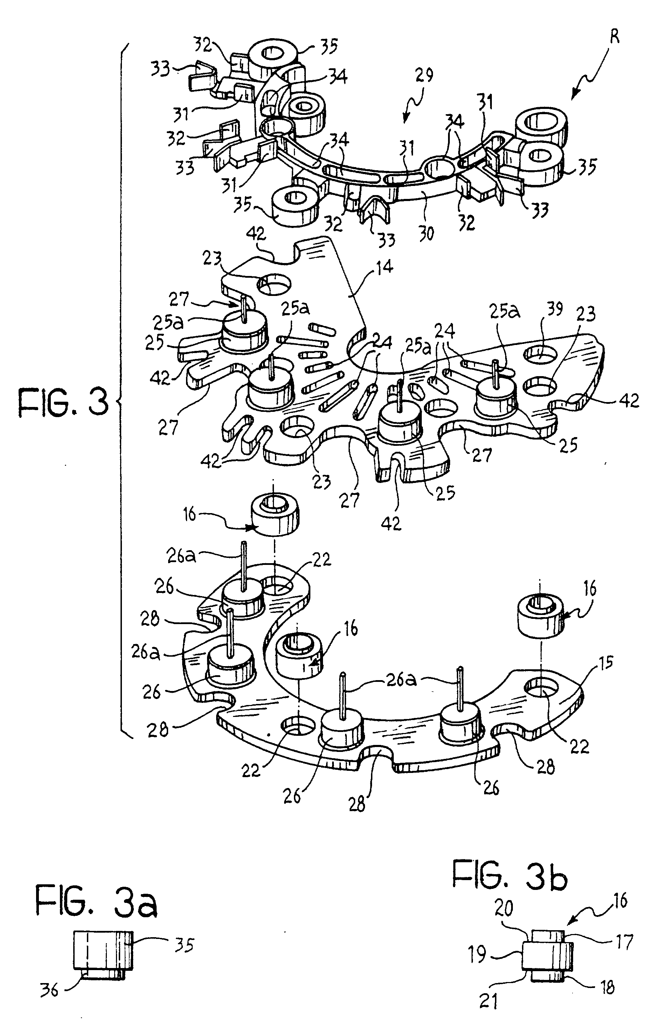

As can best be seen from Figures 2 and 3, and particularly from the latter, the rectifier R comprises a pair of generally arcuate, cooling conductor plates 14 and 15, that is, a positive plate and a negative plate, respectively. These plates are made of a metallic material, for example, aluminium or an alloy thereof. They are arranged facing and electrically insulated from one another by means of spacers 16 (Figures 3 and 3b) made of plastics material. Each spacer 16 is generally annular cylindrical with two end portions 17 and 18 of smaller outside diameter and an intermediate portion 19 with a relatively large diameter. Respective upper and lower annular abutment surfaces 20 and 21 are thus defined between these portions (Figure 3b). The end portions 17 and 18 of the spacers 16 are engageable in corresponding holes 22 in the negative plate 15 and holes 23 in the positive plate 14.

The axial length of the end portions 17 of the spacers 16 is advantageously equal to or less than half of the thickness of the positive plate 14.

As can be appreciated in particular from an observation of Figures 2 and 3, the positive plate 14 has a larger radial dimension than the negative plate 15 and a plurality of ventilation holes, indicated 24, is provided in its radially innermost portion.

The positive plate 14 carries four (positive) diodes, indicated 25 in the drawings.

Similarly, the negative plate 15 carries four (negative) diodes, indicated 26.

Each diode 25 and 26 has a respective wire rheophore or terminal 25a and 26a and a respective second, cup-shaped rheophore 25band 26b, the latter rheophore being driven into a corresponding hole in the associated conductor plate 14, 15 (see also Figure 1). The wire rheophores 25a, 26a of the diodes face in the same direction, substantially perpendicular to the respective conductor plates 14 and 15.

The arcuate outer sides of the plates have respective pluralities of peripheral notches 27 and 28 in corresponding relative positions. The notches 27 of the positive plate 14 are much larger than those of the negative plate.

Above the positive plate 14, the rectifier R comprises an interconnection structure, generally indicated 29 (Figures 2 and 3).

This interconnection structure comprises a body 30 of electrically-insulating material, such as moulded plastics material, in which four connecting conductor elements are incorporated during moulding.

Each connecting conductor element has first and second terminals 31 and 32 projecting from the insulating body 30 for connection to the rheophore 25a of a positive diode 25 and to the rheophore 26a of a negative diode 26, respectively. As can be seen in particular in Figure 3, these terminals 31 and 32 are in the form of flat tabs parallel to the rheophores of the diodes.

Each connecting conductor element of the interconnection structure 29 also has a third substantially U- or V-shaped terminal 33 projecting from the insulating body 30. These terminals extend peripherally outwardly in respective positions facing the peripheral notches 27 in the positive plate 14. Three of the terminals 33 are for connection to respective phases of the stator winding of the alternator while the fourth is for connection to the star point of the winding.

The electrical connection between the terminals 31 and 32 and the rheophores of the positive and negative diodes is advantageously formed by electric welding. The connection between the terminals 33 and the stator windings of the alternator is advantageously formed by the clamping and welding of these terminals to the conductors (not shown) for connection to the phases and to the star point of the stator winding of the alternator.

The insulating body 30 of the interconnection structure 29 advantageously has a plurality of ventilation holes or ducts 34 oriented essentially perpendicular to the body and to the conductor plates 14 and 15.

For a better understanding, a method of assembling the rectifier R will now be described purely by way of example.

The spacers 16 are positioned on the negative plate 15, which has already been provided with the negative diodes 26 with the rheophores 26a facing upwardly, the portions 18 of the spacers 16 being inserted in the holes 22 in the plate so that the annular surfaces 21 of the spacers are in abutment with the upper surface of the plate.

The positive plate 14, which has also already been provided with the respective diodes 25 with the rheophores 25a facing upwardly, is placed on the negative plate 15 so that the portions 17 of the spacers 16 are inserted in the holes 23 in the positive plate. The rheophores 26a of the negative diodes 26 extend (without contact) through the notches 27 in the positive plate, projecting beyond its upper surface.

The interconnection structure 29 is then placed over the positive plate 14. The body 30 of the structure forms three annular cylindrical locating appendages 35 with a lower portion 36 of smaller outside diameter (Figures 3 and 3a). These appendages 35 are arranged in relative positions corresponding to those of the holes 23 in the positive plate 14. During assembly, the portions 36 of the appendages 35 are inserted in the holes 23 in the positive plate 14.

In the assembled condition, the terminals 31 and 32 of the interconnection structure are in contact with the rheophores 25a of the positive diodes and with the rheophores 26a of the negative diodes, respectively.

The terminals are then welded to the rheophores of the diodes.

The rectifier bridge thus preassembled can then be fixed to the portion 12 of the alternator casing by screw ties 37 (Figures 1 and 2) which extend through the axial ducts in the spacers 16 and the corresponding ducts defined in the appendages 35 of the interconnection structure. The negative plate 15 is in contact with the portion 12 of the alternator casing, by means of which it is also connected to the negative pole of the vehicle's voltage supply and to earth.

The positive plate 14, on the other hand, is connected to the positive pole of the supply, for example, by means of a terminal 38 (Figure 2) driven into a corresponding hole 39 thereof (Figure 3).

Each of the phase and star-point terminals of the stator winding 2 can thus be connected to the respective terminals 33 of the interconnection structure 29.

Finally, the alternator is equipped with brush-holders 40 (Figure 2) with respective brushes cooperating with the commutator rings 9 and 10 as well as an integrated voltage regulator 41 which controls the current flowing in the field winding 8.

Naturally, the principle of the invention remaining the same, the forms of embodiment and details of construction may be varied widely with respect to those described and illustrated purely by way of non-limiting example.

Thus, for example, the plate 14 may have notches such as those indicated 42 in Figure 3 along its arcuate outer side (and/or along its arcuate inner side) for improving cooling.

Moreover, the negative plate 15 could be eliminated and replaced by the portion 12 (Figure 1) of the casing of the alternator A, to which the negative diodes 26 would be connected directly, in this case.

In an alternator with a three-phase winding connected in a triangular arrangement, clearly the two diodes which, with windings connected in a star arrangement, would have to be connected to the star point, are superfluous.

## Claims

1. A rectifier (R) for an alternator (A), particularly for an internal combustion engine, comprising:
a pair of facing, cooling conductor plates (14, 15), that is, a positive plate and a negative plate, which are insulated from one another and to which are connected respective sets of positive or negative diodes (25, 26) having respective wire rheophores (25a, 26a) extending in the same direction substantially perpendicular to the plates (14, 15) for connection to the phases of the alternator (A),
an interconnection structure (29) arranged substantially parallel to one of the conductor plates (14) on the opposite side to the other conductor plate (15) and comprising a body (30) of electrically-insulating material incorporating connecting conductor elements insulated from one another and each having a first terminal and a second terminal (31, 32) for connection to the rheophores (25a, 26a) of a positive (25) and of a negative diode (26), respectively, and a third terminal (33) for connection to a phase of the armature winding (2) of the alternator, the terminals (31, 33) projecting from the body (30),
**characterized in that** the outer sides of the positive and negative plates (14, 15) have respective pluralities of peripheral notches (27, 28) in corresponding relative positions and facing the third terminals (33) of the interconnection structure (29), the peripheral notches (27) of the conductor plate (14) which is disposed between the interconnection structure (29) and the other conductor plate (15) being of a size such that the wire rheophores (26a) of the diodes (26) carried by the other plate (15) extend through them.

2. A rectifier according to Claim 1, **characterized in that** the first and second terminals (31, 32) of the interconnection structure (29) are flat and are parallel to the rheophores (25a, 26a) of the diodes (25, 26).

3. A rectifier according to Claim 1 or Claim 2, **characterized in that** the conductor plate (14) which is disposed between the interconnection structure (29) and the other plate (15) has a plurality of ventilation holes (24).

4. A rectifier according to Claim 1 or Claim 2, **characterized in that** the conductor plate (14) which is disposed between the interconnection structure (29) and the other plate (15) is the positive plate.

5. A rectifier according to any one of the preceding claims, for an alternator (A) with a three-phase armature winding (2) connected in a star arrangement,
**characterized in that** each of the positive and negative plates (14, 15) carries three positive or negative diodes (25, 26), respectively, which are connected to the three phases of the alternator by means of corresponding connection elements of the interconnection structure (29), and a respective further diode (25, 26) connected to the star point of the stator winding (2) of the alternator (A) by means of a further connection element of the interconnection structure (29).

6. A rectifier according to any one of the preceding claims, **characterized in that** each diode (25, 26) has a respective second, substantially cup-shaped rheophore (25b, 26b) driven into a corresponding hole in the associated conductor plate (14, 15).

7. A rectifier according to Claim 3, **characterized in that** the plate (14) which is disposed between the interconnection structure (29) and the other plate (15) has a larger radial dimension than the other plate (15) and the ventilation holes (24) are at least partially formed in the radially innermost portion of the first plate (14).

8. A rectifier according to any one of the preceding claims, **characterized in that** the insulating body (30) of the interconnection structure (29) has a plurality of ventilation holes (34) oriented substantially perpendicular to the body (30) and to the conductor plates (14, 15).

## Patentansprüche

1. Gleichrichter (R) für einen Wechselstromgenerator (A), im Besonderen für einen Verbrennungsmotor, wobei der Gleichrichter enthält:
ein Paar von einander gegenüber liegenden, leitenden Kühlplatten (14, 15), und zwar einer positiven Platte und einer negativen Platte, die gegeneinander isoliert und mit entsprechenden Reihen von positiven oder negativen Dioden (25, 26) verbunden sind, die entsprechende Drahtelektroden (25a, 26a) besitzen, die in die selbe Richtung im Wesentlichen senkrecht zu den Platten (14, 15) verlaufen, um eine Verbindung mit den Phasen des Generators (A) herzustellen, und
eine Innenverbindung (29), die im Wesentlichen parallel zu einer der leitenden Platten (14) an der der anderen leitenden Platte (15) gegenüber liegenden Seite angeordnet ist und einen Körper (30) aus einem elektrisch isolierenden Werkstoff besitzt, der leitende Verbindungselemente enthält, die voneinander isoliert sind und von denen jedes einen ersten Anschluss und einen zweiten Anschluss (31, 32), um mit den Elektroden (25a, 26a) einer positiven Diode (25) bzw. einer negativen Diode (26) verbunden zu werden, sowie einen dritten Anschluss (33) besitzt, um mit einer Phase der Ankerwicklung (2) des Generators verbunden zu werden, wobei die Anschlüsse (31, 33) vom Körper (30) vorspringen,
**dadurch gekennzeichnet, dass** die Außenseiten der positiven und der negativen Platte (14, 15) eine entsprechende Vielzahl von peripheren Einkerbungen (27, 28) an entsprechenden relativen Stellen besitzen, wobei sie den dritten. Anschlüssen (33) der Innenverbindung (29) gegenüber liegen, wobei die peripheren Einkerbungen (27) der leitenden Platte (14), die zwischen der Innenverbindung (29) und der äußeren leitenden Platte (15) liegt, so groß sind, dass die Drahtelektroden (26a) der Dioden (26), die von der anderen Platte (15) getragen werden, durch sie verlaufen.

2. Gleichrichter gemäß Anspruch 1, **dadurch gekennzeichnet, dass** der erste und der zweite Anschluss (31, 32) der Innenverbindung (29) flach und parallel zu den Elektroden (25a, 26a) der Dioden (25, 26) verlaufen.

3. Gleichrichter gemäß Anspruch 1 oder Anspruch 2, **dadurch gekennzeichnet, dass** die leitende Platte (14), die zwischen der Innenverbindung (29) und der anderen Platte (15) angeordnet ist, eine Vielzahl von Lüftungsöffnungen (24) besitzt.

4. Gleichrichter gemäß Anspruch 1 oder Anspruch 2, **dadurch gekennzeichnet, dass** die leitende Platte (14), die zwischen der Innenverbindung (29) und der anderen Platte (15) angeordnet ist, die positive Platte ist.

5. Gleichrichter gemäß irgendeinem der bisherigen Ansprüche für einen Generator (A) mit einer dreiphasigen Ankerwicklung (2), die im Stern geschaltet ist,
**dadurch gekennzeichnet, dass** sowohl die positive als auch die negative Platte (14, 15) drei positive bzw. negative Dioden (25, 26), die mit den drei Phasen des Generators über entsprechende Verbindungselemente der Innenverbindung (29) verbunden sind, sowie eine entsprechende weitere Diode (25, 26) trägt, die mit dem Sternpunkt der Statorwicklung (2) des Generators (A) über ein weiters Verbindungselement der Innenverbindung (29) verbunden ist.

6. Gleichrichter gemäß irgendeinem der bisherigen Ansprüche, **dadurch gekennzeichnet, dass** jede Diode (25, 26) eine entsprechende zweite im Wesentlichen schalenförmige Elektrode (25b, 26b) besitzt, .die in eine entsprechende Öffnung in der zugeordneten leitenden Platte (14, 15) getrieben wird.

7. Gleichrichter gemäß Anspruch 3, **dadurch gekennzeichnet, dass** die Platte (14), die zwischen der Innenverbindung (29) und der anderen Platte (15) angeordnet ist, eine größere Radialabmessung als die andere Platte (15) besitzt und dass die Lüftungsöffnungen (24) zumindest teilweise radial ganz innen auf der ersten Platte (14) ausgebildet sind.

8. Gleichrichter gemäß irgendeinem der bisherigen Ansprüche, **dadurch gekennzeichnet, dass** der Isolierkörper (30) der Innenverbindung (29) eine Vielzahl von Lüftungsöffnungen (34) besitzt, die im Wesentlichen senkrecht zum Körper (30) und zu den leitenden Platten (14, 15) ausgerichtet sind.

## Revendications

1. Redresseur (R) pour alternateur (A), notamment pour moteur à combustion interne, comprenant :
une paire de plaques conductrices de refroidissement (14, 15) situées en face l'une de l'autre, à savoir une plaque positive et une plaque négative, qui sont isolées l'une de l'autre et auxquelles sont connectés les ensembles respectifs de diodes positives ou négatives (25, 26) ayant des fils rhéophores (25a, 26a) s'étendant dans la même direction, sensiblement perpendiculairement aux plaques (14, 15) pour une connexion aux phases de l'alternateur (A),
une structure d'interconnexion (29) agencée sensiblement parallèlement à l'une des plaques conductrices (14) du côté opposé à l'autre plaque conductrice (15) et comprenant un corps (30) de matériau électriquement isolant comportant des éléments conducteurs de connexion isolés les uns des autres et ayant chacun une première borne et une seconde borne (31, 32) pour une connexion aux fils rhéophores (25a, 26a) respectifs d'une diode positive (25) et d'une diode négative (26), et une troisième borne (33) pour une connexion à une phase de l'enroulement d'induit (2) de l'alternateur, les bornes (31, 33) dépassant du corps (30),
**caractérisé en ce que** les faces extérieures des plaques positives et négatives (14, 15) ont des pluralités respectives d'encoches périphériques (27, 28) à des positions relatives correspondantes et situées en face des troisièmes bornes (33) de la structure d'interconnexion (29), les encoches périphériques (27) de la plaque conductrice (14) qui est disposée entre la structure d'interconnexion (29) et l'autre plaque conductrice (15) ayant une taille telle que les fils rhéophores (26a) des diodes (26) portées par l'autre plaque (15) passent à travers celles-ci.

2. Redresseur selon la revendication 1, **caractérisé en ce que** les première et seconde bornes (31, 32) de la structure d'interconnexion (29) sont planes et sont parallèles aux fils rhéophores (25a, 26a) des diodes (25, 26).

3. Redresseur selon la revendication 1 ou 2, **caractérisé en ce que** la plaque conductrice (14) qui est disposée entre la structure d'interconnexion (29) et l'autre plaque (15) présente une pluralité de trous de ventilation (24).

4. Redresseur selon la revendication 1 ou 2, **caractérisé en ce que** la plaque conductrice (14) qui est disposée entre la structure d'interconnexion (29) et l'autre plaque (15) est la plaque positive.

5. Redresseur selon l'une quelconque des revendications précédentes, pour un alternateur (A) ayant un enroulement d'induit triphasé (2) connecté en étoile,
**caractérisé en ce que** chacune des plaques positive et négative (14, 15) porte trois diodes positives ou négatives (25, 26) respectives qui sont connectées aux trois phases de l'alternateur au moyen d'éléments de connexion correspondants de la structure d'interconnexion (29), et une autre diode respective (25, 26) connectée au point d'étoile de l'enroulement de stator (2) de l'alternateur (A) au moyen d'un autre élément de connexion de la structure d'interconnexion (29).

6. Redresseur selon l'une quelconque des revendications précédentes, **caractérisé en ce que** chaque diode (25, 26) comporte un second fil rhéophore respectif ayant sensiblement la forme d'une coupelle (25b, 26b) inséré dans un trou correspondant pratiqué dans la plaque conductrice associée (14, 15).

7. Redresseur selon la revendication 3, **caractérisé en ce que** la plaque (14) qui est disposée entre la structure d'interconnexion (29) et l'autre plaque (15) présente une dimension radiale plus importante que l'autre plaque (15) et **en ce que** les trous de ventilation (24) sont au moins partiellement formés dans la partie radialement intérieure de la première plaque (14).

8. Redresseur selon l'une quelconque des revendications précédentes, caractérisé en ce le corps isolant (30) de la structure d'interconnexion (29) présente une pluralité de trous de ventilation (34) orientés sensiblement perpendiculairement au corps (30) et aux plaques conductrices (14, 15).
